# EUROPEAN PATENT APPLICATION

(11) **EP 4 521 761 A1**
(43) Date of publication of application: **12.03.2025**
(21) Application number: 23829981.2
(22) Date of filing: 14.06.2023
(51) Int. Cl.: H04N 23/57

(54) **CAMERA MODULE AND ELECTRONIC DEVICE**

(30) Priority: 28.06.2022 CN 202210740020
(71) Applicant: Huawei Technologies Co., Ltd., Shenzhen, Guangdong 518129 (CN)
(72) Inventor: AN, Qi, Shenzhen, Guangdong 518129 (CN); DING, Zhaoyuan, Shenzhen, Guangdong 518129 (CN); HUANG, Changfu, Shenzhen, Guangdong 518129 (CN); QIN, Shixin, Shenzhen, Guangdong 518129 (CN)
(74) Representative: Maiwald GmbH
(86) International application number: PCT/CN2023/100291
(87) International publication number: WO 2024/001800

(57) **Abstract**

Embodiments of this application provide a camera module and an electronic device. The camera module includes at least an imaging unit and a position detection unit. The imaging unit includes a moving component moving in a first direction. The position detection unit includes two movable members and two groups of stationary units. The two movable members are respectively fastened and mounted at two opposite ends of the moving component and located between the two groups of stationary units. The two movable members are disposed at a spacing in a second direction. Each group of stationary units includes at least one stationary member. The two groups of stationary units are disposed opposite to each other in the second direction. One of the movable member and the stationary member is a magnetic body, and the other of the movable member and the stationary member is a magnetic sensor. The magnetic sensor is configured to detect magnetic field strength of the magnetic body corresponding to the magnetic sensor. The magnetic sensor and the magnetic body that cooperate with each other are disposed on two sides of the moving component, to compensate for a precision error caused by a change of the spacing between the magnetic body and magnetic sensor, and improve position detection precision.

## Description

This application claims priority to Chinese Patent Application No. 202210740020.7, filed with the China National Intellectual Property Administration on June 28, 2022 and entitled "CAMERA MODULE AND ELECTRONIC DEVICE", which is incorporated herein by reference in its entirety.

### TECHNICAL FIELD

Embodiments of this application relate to the field of terminal technologies, and in particular, to a camera module and an electronic device.

### BACKGROUND

In a camera module, to compensate for and correct impact of jitter and implement an automatic zoom function, a sensor with a high-precision position detection function needs to be used for position feedback.

A camera module in a conventional technology cooperates with a plurality of Hall effect sensors by using an induction magnet, to implement position detection. The induction magnet is disposed on a moving component of the camera module. The plurality of Hall effect sensors are arranged at equal spacings in a movement direction of the induction magnet and are disposed facing the induction magnet. A plurality of magnetic field signals detected by using the plurality of Hall effect sensors may be used to determine whether the moving component is at a predetermined position.

However, position detection precision for the moving component of the camera module in the conventional technology is low.

### SUMMARY

Embodiments of this application provide a camera module and an electronic device, to compensate for a precision error caused by a dynamic change of a spacing between a magnetic body and a magnetic sensor, and improve position detection precision for a moving component of the camera module.

A first aspect of this application provides a camera module, including at least an imaging unit and a position detection unit. The imaging unit includes a moving component moving in a first direction. The position detection unit includes two movable members and two groups of stationary units. The two movable members are respectively fastened and mounted at two opposite ends of the moving component and located between the two groups of stationary units. The two movable members are disposed at a spacing in a second direction. The second direction is perpendicular to the first direction. Each group of stationary units includes at least one stationary member. The two groups of stationary units are disposed opposite to each other in the second direction. When each group of stationary units includes a plurality of stationary members, the plurality of stationary members of each group of stationary units are disposed at spacings in the first direction. One of the movable member and the stationary member is a magnetic body, and the other of the movable member and the stationary member is a magnetic sensor. The magnetic sensor is configured to detect magnetic field strength of the magnetic body corresponding to the magnetic sensor.

According to the camera module provided in this embodiment of this application, one of the stationary member and the movable member is a magnetic body, and the other is a magnetic sensor. For example, the movable member is a magnetic body, and the stationary member is a magnetic sensor. When the moving component in this embodiment of this application moves in the second direction, a spacing between the moving component and one group of stationary units increases, and a spacing between the moving component and the other group of stationary units decreases. Correspondingly, magnetic field strength detected by the one group of stationary units decreases, and magnetic field strength detected by the other group of stationary units increases. An addition or subtraction operation is performed on the magnetic field strength detected by the two groups of stationary units, to compensate for a precision error caused by a change of the spacing between the magnetic body and magnetic sensor, and improve position detection precision for the moving component.

In a possible implementation, the movable member is a magnetic sensor, and the stationary member is a magnetic body.

In a possible implementation, the movable member is a magnetic body, and the stationary member is a magnetic sensor.

In a possible implementation, each group of stationary units includes a same quantity of stationary members.

In a possible implementation, each group of stationary units includes one stationary member, two stationary members, or three stationary members.

In a possible implementation, all stationary members of the one group of stationary units are in a one-to-one correspondence with all stationary members of the other group of stationary units.

In a possible implementation, the two groups of stationary units have different quantities of stationary members.

In a possible implementation, a difference between a quantity of stationary members of the one group of stationary units of the two groups of stationary units and a quantity of stationary members of the other group of stationary units is 1, 2, or 3.

In a possible implementation, the one group of stationary units includes one stationary member, and the other group of stationary units includes two or three stationary members.

In a possible implementation, when the other group of stationary units includes two stationary members, the stationary member of the one group of stationary units is located in the middle relative to the two stationary members of the other group of stationary units.

In a possible implementation, when the other group of stationary units includes three stationary members, the stationary member of the one group of stationary units is disposed opposite to a stationary member in the middle of the three stationary members of the other group of stationary units in the second direction.

In a possible implementation, the two magnetic bodies are disposed in the second direction in an attracted manner, or the two magnetic bodies are disposed in the second direction in a repelled manner.

In a possible implementation, the magnetic sensor is any one of the following sensors: a Hall effect sensor, a giant magnetoresistance sensor, a tunneling magnetoresistance sensor, an anisotropic magnetoresistance sensor, or a sensor-integrated signal processing chip.

In a possible implementation, the moving component is a lens group or a photosensitive chip. The lens group includes at least one lens moving in the first direction. When the moving component is the lens group, the lens group includes at least one lens moving in the first direction, and the two movable members are fastened and mounted on a same lens.

In a possible implementation, a control unit is further included. Each magnetic sensor is electrically connected to the control unit. The control unit is configured to receive a magnetic field signal uploaded by each magnetic sensor, and determine a position of the moving component based on all magnetic field signals.

In a possible implementation, a driving unit is further included. The driving unit is electrically connected to the control unit and is mechanically connected to the moving component. The control unit is further configured to control, based on the magnetic field signal, the driving unit to drive the moving component to move in the first direction.

In a possible implementation, each magnetic sensor is electrically connected to the control unit.

In a possible implementation, all magnetic sensors of each group of stationary units are electrically connected to a same connection end of the control unit.

In a possible implementation, the magnetic body is a magnetite or a magnet.

A second aspect of this application provides an electronic device, including a housing and the camera module according to any one of the foregoing implementations. The camera module is disposed on the housing.

### BRIEF DESCRIPTION OF DRAWINGS

FIG. 1 is a diagram of a structure of a camera module in a conventional technology;
FIG. 2 is a diagram of a relative distance between an induction magnet and a Hall effect sensor in a conventional technology;
FIG. 3 is a diagram of units of a camera module according to an embodiment of this application;
FIG. 4 is a diagram of an application scenario of a camera module according to an embodiment of this application;
FIG. 5 is a diagram of a structure of a camera module according to an embodiment of this application;
FIG. 6 is a diagram of a rightward deviation of a magnetic body in a second direction according to an embodiment of this application;
FIG. 7 is a diagram in which sensing directions of magnetic sensors on two sides of a moving component are the same according to an embodiment of this application;
FIG. 8 is a diagram in which sensing directions of magnetic sensors on two sides of a moving component are opposite according to an embodiment of this application;
FIG. 9 is a diagram of detection effect of an embodiment shown in FIG. 6;
FIG. 10 is a diagram of detection effect of a camera module in a conventional technology;
FIG. 11 is a diagram of a structure of a first position detection unit according to an embodiment of this application;
FIG. 12 is a diagram of a structure of a second position detection unit according to an embodiment of this application;
FIG. 13 is a diagram of a structure of a third position detection unit according to an embodiment of this application;
FIG. 14 is a diagram of a structure of a fourth position detection unit according to an embodiment of this application;
FIG. 15 is a diagram of a structure of a fifth position detection unit according to an embodiment of this application;
FIG. 16 is a diagram of a structure of a sixth position detection unit according to an embodiment of this application;
FIG. 17 is a diagram of a structure of a seventh position detection unit according to an embodiment of this application;
FIG. 18 is a diagram of a structure of an eighth position detection unit according to an embodiment of this application;
FIG. 19 is a diagram in which two magnetic bodies are disposed in an attracted manner according to an embodiment of this application;
FIG. 20 is another diagram in which two magnetic bodies are disposed in an attracted manner according to an embodiment of this application;
FIG. 21 is a diagram in which two magnetic bodies are disposed in a repelled manner according to an embodiment of this application;
FIG. 22 is another diagram in which two magnetic bodies are disposed in a repelled manner according to an embodiment of this application;
FIG. 23 is a diagram of cooperation between a magnetic body and a magnetic sensor according to an embodiment of this application;
FIG. 24 is another diagram of cooperation between a magnetic body and a magnetic sensor according to an embodiment of this application;
FIG. 25 is still another diagram of cooperation between a magnetic body and a magnetic sensor according to an embodiment of this application;
FIG. 26 is a diagram of a connection between a magnetic sensor and a control unit according to an embodiment of this application;
FIG. 27 is a diagram of another connection between a magnetic sensor and a control unit according to an embodiment of this application; and
FIG. 28 is a diagram of still another connection between a magnetic sensor and a control unit according to an embodiment of this application.

Descriptions of reference signs:
10: camera module;
100: imaging unit;
110: moving component;
120: lens group;
130: photosensitive chip;
200: position detection unit;
210: movable member;
220: stationary unit;
221: stationary member;
230: magnetic body;
240: magnetic sensor;
300: control unit;
400: driving unit;
500: amplifier;
600: analog-to-digital converter;
20: light source;
710: Hall effect sensor; 720: induction magnet; 730: moving member; 740: processor;
X: first direction;
Y: second direction.

### DESCRIPTION OF EMBODIMENTS

As functions of an electronic device are increasingly powerful, the electronic device usually includes a camera module 10. The camera module 10 may photograph and collect external imagery, so that the electronic device implements a function such as photographing or video call. The electronic device may be a common terminal such as a mobile phone, a tablet computer, a notebook computer, or a palmtop computer (personal digital assistant, PDA). During photographing, to improve photographing quality of the camera module 10, the camera module 10 of an increasing quantity of electronic devices is configured with a stabilization function and an automatic zoom function. Both the stabilization function and the automatic zoom function need to use a sensor with a high-precision position detection function for position feedback.

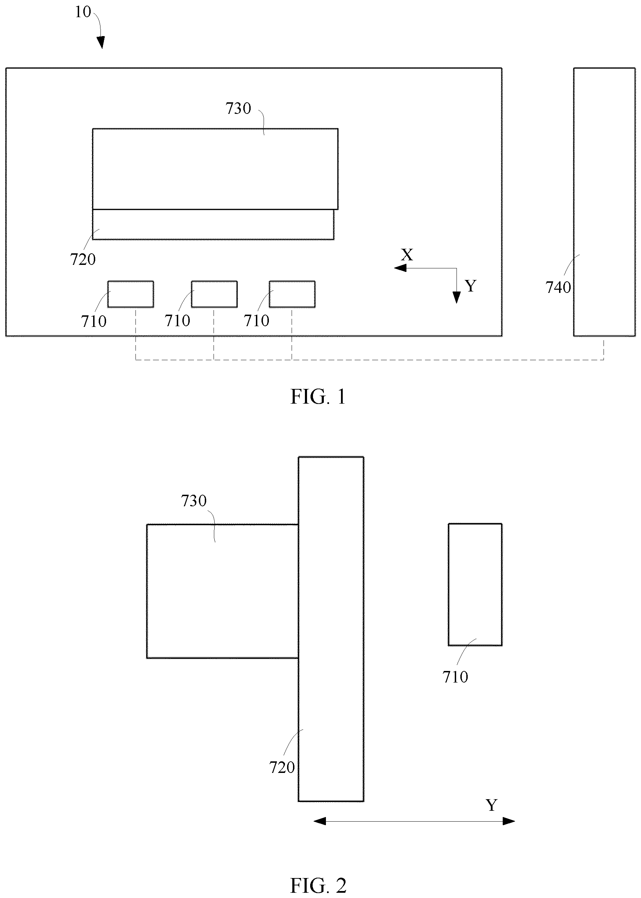

FIG. 1 is a diagram of a structure of a camera module in a conventional technology. FIG. 2 is a diagram of a relative distance between an induction magnet and a Hall effect sensor in a conventional technology.

As shown in FIG. 1 and FIG. 2, a camera module 10 in a conventional technology cooperates with a plurality of Hall effect sensors 710 by using a single induction magnet 720, to detect a position of a moving member 730 of the camera module 10. The moving member 730 may be a moving lens of the camera module 10. The moving lens is moved, to implement a zoom function. The induction magnet 720 is fastened and mounted on the moving member 730. The moving member 730 may drive the induction magnet 720 to move in an X direction in FIG. 1. The plurality of Hall effect sensors 710 are disposed at spacings in a movement direction (referring to the X direction in FIG. 1) of the induction magnet 720 and are disposed facing the induction magnet 720. The plurality of Hall effect sensors 710 remain stationary relative to the induction magnet 720. The plurality of Hall effect sensors 710 send detected magnetic field strength to a processor 740 of the camera module 10. The processor 740 determines a current position of the moving member 730 based on the received magnetic field strength. However, when a relative distance (for example, a distance in a Y direction in FIG. 1, or a distance in a Y direction in FIG. 2) between the induction magnet 720 and the Hall effect sensor 710 changes, the magnetic field strength detected by the Hall effect sensor 710 also changes. Consequently, detection precision changes, and position detection precision is reduced. For example, when the relative distance between the Hall effect sensor 710 and the induction magnet 720 decreases, and the moving member 730 moves to a predetermined position, the magnetic field strength detected by the Hall effect sensor 710 may increase. The processor 740 may adjust a movement distance of the moving member 730 based on current magnetic field strength detected by the Hall effect sensor 710, so that the magnetic field strength detected by the Hall effect sensor 710 is the same as magnetic field strength corresponding to the predetermined position. However, after the adjustment, consequently, an actual position of the moving member 730 deviates from the predetermined position. Therefore, when the relative distance between the induction magnet 720 and the Hall effect sensor 710 changes, a precision error is caused, and magnetic field strength detected by a magnetic sensor 240 is inaccurate, reducing position detection precision.

On this basis, an embodiment of this application provides an electronic device. The electronic device includes a housing and a camera module 10 disposed on the housing. A shape of the housing may depend on a type of the electronic device. For example, when the electronic device is a mobile phone, the shape of the housing may be a rectangular flat plate structure. In addition, the camera module 10 may be embedded on a side wall of the housing.

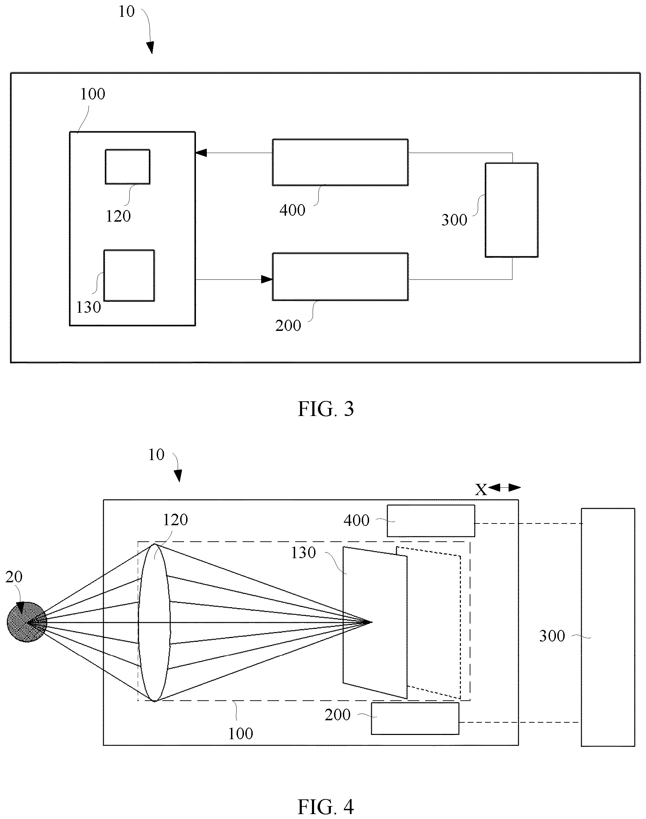

FIG. 3 is a diagram of units of a camera module according to an embodiment of this application. FIG. 4 is a diagram of an application scenario of a camera module according to an embodiment of this application.

As shown in FIG. 3, in this embodiment of this application, the camera module 10 includes at least an imaging unit 100, a position detection unit 200, a control unit 300, and a driving unit 400. The imaging unit 100 is configured to receive light emitted by a light source 20, and process the received light to form an image. In some examples, as shown in FIG. 4, the imaging unit 100 may include at least a lens group 120 and a photosensitive chip 130 that are disposed in a stacked manner in a direction of an optical axis. The lens group 120 is configured to project light emitted by the external light source 20 onto the photosensitive chip 130, and the photosensitive chip 130 processes the received light to form an image. To implement an automatic zoom function of the camera module 10, the lens group 120 or the photosensitive chip 130 may be moved. Therefore, the lens group 120 may serve as a moving component 110, or the photosensitive chip 130 may serve as a moving component 110. For example, as shown in FIG. 4, the photosensitive chip 130 serves as the moving component 110.

In this embodiment of this application, the driving unit 400 is electrically connected to the control unit 300 and is mechanically connected to the moving component 110, so that the driving unit 400 can enable the moving component 110 to move to a target position. For example, as shown in FIG. 4, when the moving component 110 is the photosensitive chip 130, the photosensitive chip 130 may move from a position indicated by a dashed line to a position indicated by a solid line in an X direction in FIG. 4 under an action of the driving unit 400, to change a position of the photosensitive chip 130 in the X direction in FIG. 4, and implement the automatic zoom function.

In this embodiment of this application, the control unit 300 is electrically connected to the position detection unit 200 and the driving unit 400. The control unit 300 may control the driving unit 400 based on a current position, detected by the position detection unit 200, of the moving component 110, to ensure that the moving component 110 can move to the target position, to meet a use requirement.

In this embodiment of this application, the position detection unit 200 includes a magnetic body 230 and a magnetic sensor 240. The magnetic body 230 and the magnetic sensor 240 are disposed on each of two opposite sides of the moving component 110. Each magnetic body 230 cooperates with at least one magnetic sensor 240. When a spacing between one magnetic body 230 and a magnetic sensor 240 corresponding to the magnetic body 230 increases, a spacing between the other magnetic body 230 and a magnetic sensor 240 corresponding to the magnetic body 230 decreases. Therefore, magnetic field strength detected by a magnetic sensor 240 on one side of the moving component 110 increases, and magnetic field strength detected by a magnetic sensor 240 on the other side decreases. A spacing between the magnetic sensors 240 on the two sides remains unchanged. Therefore, an operation may be performed on the magnetic field strength detected by the magnetic sensors 240 on the two sides, to compensate for a precision error caused by a change of the spacing between the magnetic body 230 and the magnetic sensor 240, improve accuracy of the magnetic field strength detected by the magnetic sensor 240, and improve position detection precision.

It can be understood that each magnetic sensor 240 is electrically connected to the control unit 300, and each magnetic sensor 240 is configured to convert captured magnetic field strength into a magnetic field signal and is capable of uploading the magnetic field signal to the control unit 300. Then the control unit 300 determines a current position of the moving component 110 based on all received magnetic field signals.

It should be noted that an application scenario in which an arrangement manner of the magnetic sensor 240 and the magnetic body 230 provided in this embodiment of this application is used is the camera module 10. The magnetic sensor 240 and the magnetic body 230 are configured to determine the position of the moving component 110 of the imaging unit 100, to implement an automatic zoom function and compensate for and correct impact of jitter. Certainly, an application scenario in which an arrangement manner of the magnetic sensor 240 and the magnetic body 230 provided in this embodiment of this application is used is not limited to the camera module 10. For example, the arrangement manner of the magnetic sensor 240 and the magnetic body 230 provided in this embodiment of this application may be further used in an application scenario in which a relative position of a moving component is detected and fed back, for example, an industrial machine tool or a robot.

The following describes an implementation of the camera module 10 provided in this embodiment of this application.

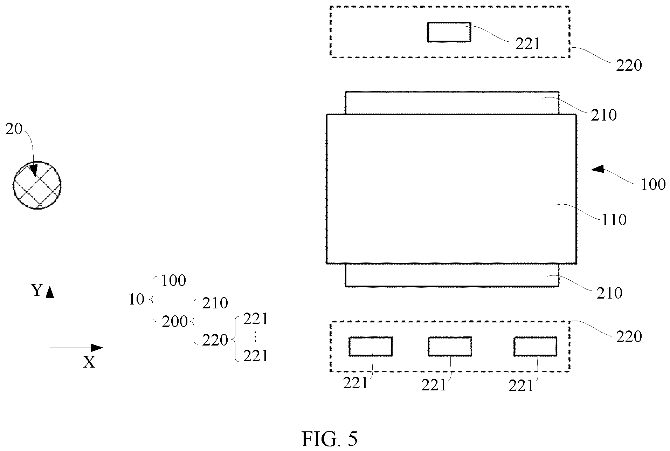

FIG. 5 is a diagram of a structure of a camera module according to an embodiment of this application.

As shown in FIG. 5, the camera module 10 in this embodiment of this application includes at least an imaging unit 100 and a position detection unit 220. The imaging unit 100 is configured to receive light emitted by an external light source 20 and process the received light to form an image. The imaging unit 100 may include a moving component 110 moving in a first direction (for example, an X direction in FIG. 5). A position of the moving component 110 in the first direction may be changed to implement an automatic zoom function, to meet a photographing requirement of a user. For example, the moving component 110 may be a lens group 120 or a photosensitive chip 130 of the imaging unit 100.

The position detection unit 220 is configured to detect a position of the moving component 110, to ensure that the moving component 110 can move to a target position. The position detection unit 220 may include two movable members 210 and two groups of stationary units 220. The two movable members 210 are respectively fastened and mounted at two opposite ends of the moving component 110. The movable member 210 may move in the first direction with the moving component 110. It should be noted that when the moving component 110 is the lens group 120, the lens group 120 may include at least one lens moving in the first direction, and the two movable members 210 are fastened and mounted on a same lens. The two movable members 210 are disposed at a spacing in a second direction and located between the two groups of stationary units 220. Each movable member 210 corresponds to one group of stationary units 220, and the movable member 210 and the stationary units 220 are disposed at spacings in the second direction (for example, a Y direction in FIG. 5). The second direction is perpendicular to the first direction.

It can be understood that, in a process in which the moving component 110 moves in the first direction, a position of the stationary unit 220 relative to the moving component 110 remains unchanged, so that detection difficulty can be reduced. In addition, the stationary unit 220 may be disposed near the target position. When the moving component 110 moves to the target position, an actual position of the moving component 110 may be determined based on both the stationary unit 220 and the movable member 210. The stationary unit 220 may be disposed on a non-moving component of the camera module 10, or the stationary unit 220 may be disposed on a non-moving component of an electronic device. For example, the stationary unit 220 may be disposed on a housing of the camera module 10, or when a stationary member 221 of the stationary unit 220 is a sensor, the stationary unit 220 may be disposed on a printed circuit board of the camera module 10. This is not specifically limited herein.

Each group of stationary units 220 may include at least one stationary member 221. To be specific, each group of stationary units 220 may include 1, 2, 3, 4, or 10 stationary members 221, or the like. When each group of stationary units 220 includes a plurality of stationary members 221, the plurality of stationary members 221 of each group of stationary units 220 are disposed at spacings in the first direction. A quantity of the plurality of stationary members 221 may be a positive integer such as 2, 3, 4, 5, 6, 7, 8, 9, 10, 11, 12, 13, 14, or 1516. In addition, the two groups of stationary units 220 are disposed opposite to each other in the second direction. This disposing helps improve an overlapping degree of a magnetic field strength-stroke curve formed by fitting magnetic field strength detected by the two groups of stationary units 220 and stroke data, and helps improve detection precision.

One of the movable member 210 and the stationary member 221 is a magnetic body 230, and the other of the movable member 210 and the stationary member 221 is a magnetic sensor 240. The magnetic sensor 240 is configured to detect magnetic field strength of a magnetic body 230 corresponding to the magnetic sensor 240. The magnetic body 230 may be a magnetite, a magnet, or a magnetic field generator capable of generating a magnetic field. It can be understood that the movable member 210 moves with the moving component 110, and a position of the stationary member 221 remains unchanged. Therefore, when the magnetic body 230 is the movable member 210, correspondingly, the magnetic sensor 240 is the stationary member 221. Alternatively, when the magnetic sensor 240 is the movable member 210, correspondingly, the magnetic body 230 is the stationary member 221. When the magnetic body 230 is the movable member 210 and the magnetic sensor 240 is the stationary member 221, this helps reduce arrangement difficulty and detection difficulty of the position detection unit 220.

When the magnetic field strength of the magnetic body 230 is detected, the magnetic sensor 240 may convert the magnetic field strength into a magnetic field signal, and send the magnetic field signal to a control unit 300. The control unit 300 may determine, based on the magnetic field signal, whether the moving component 110 has moved to the target position. A detection principle of determining, by the control unit 300, the position of the moving component 110 based on the magnetic field signal is as follows: A stroke of the moving component 110 is in a linear relationship with the magnetic field strength. To be specific, each stroke value of the moving component 110 in the first direction corresponds to unique determined magnetic field strength. When current magnetic field strength detected by the magnetic sensor 240 is equal to determined magnetic field strength at the target position, it may be learned that the moving component 110 has moved to the target position. When current magnetic field strength detected by the magnetic sensor 240 deviates from determined magnetic field strength at the target position, the control unit 300 may control a movement distance of the moving component 110 based on a deviation value between the current magnetic field strength detected by the magnetic sensor 240 and the determined magnetic field strength at the target position, to ensure that the moving component 110 moves to the target position.

The following describes in detail a principle of compensating for a precision error in this embodiment of this application by using an example in which the movable member 210 is a magnetic body 230, the stationary member 221 is a magnetic sensor 240, and each magnetic body 230 corresponds to two magnetic sensors 240.

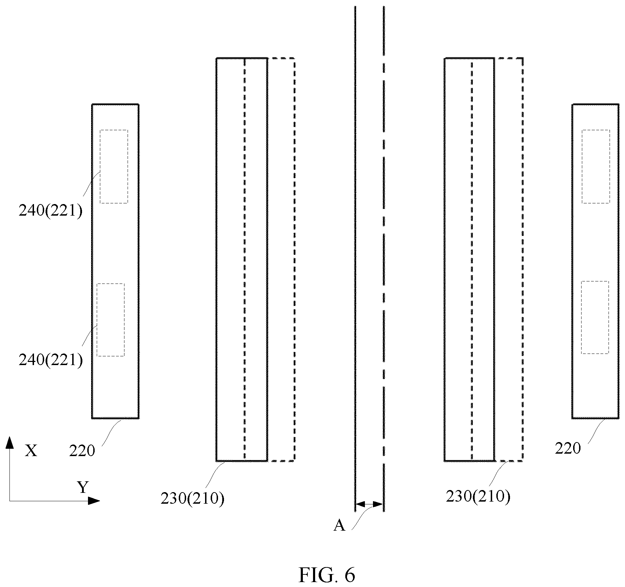

FIG. 6 is a diagram of a rightward deviation of a magnetic body in a second direction according to an embodiment of this application. As shown in FIG. 6, when two magnetic bodies 230 deviate rightward by a specific distance (for example, A in FIG. 6) in a second direction, a spacing in the second direction between a magnetic body 230 on a right side of a moving component 110 (not shown in FIG. 6) and a magnetic sensor 240 on a right side decreases, so that magnetic field strength detected by the magnetic sensor 240 on the right side increases. A spacing in the second direction between a magnetic body 230 on a left side of the moving component 110 and a magnetic sensor 240 on a left side increases, so that magnetic field strength detected by the magnetic sensor 240 on the left side decreases. The spacing in the second direction between the magnetic sensors 240 on the two sides remains unchanged. Therefore, it is different from magnetic field strength detected when the rightward deviation is not performed in that an increased part of the magnetic field strength detected by the magnetic sensor 240 on the right side after the deviation is approximately equal to a decreased part of the magnetic field strength detected by the magnetic sensor 240 on the left side after the deviation. As a result, a corresponding calculation is performed on the magnetic field strength detected by the magnetic sensor 240 on the left side and the magnetic field strength detected by the magnetic sensor 240 on the right side, to ensure that, in a same stroke, a value of a magnetic field sensed by the magnetic sensor 240 is basically not affected by a change of the spacing between the magnetic body 230 and the magnetic sensor 240 corresponding to the magnetic body 230. This helps reduce a precision error, to improve position detection precision.

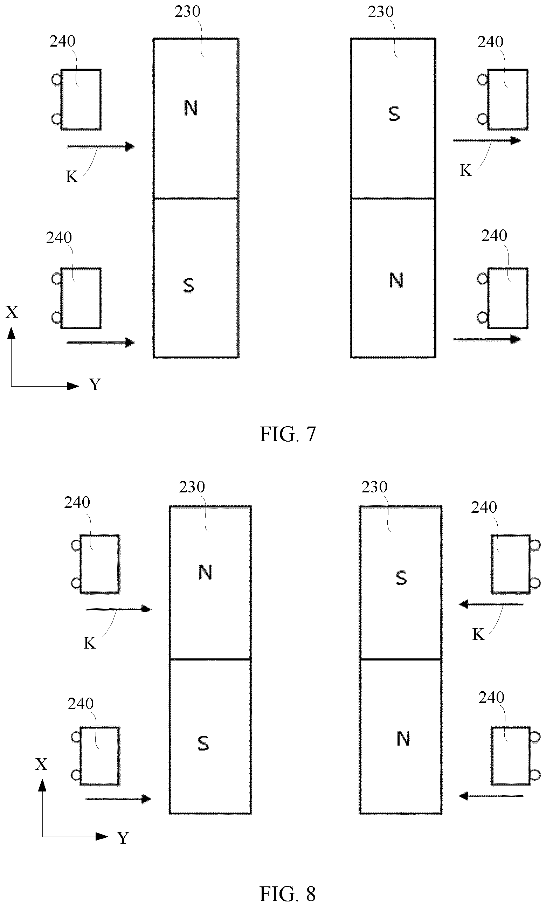

An operation manner (addition or subtraction) of the magnetic field strength detected by the magnetic sensor 240 on the left side and the magnetic field strength detected by the magnetic sensor 240 on the right side depends on an arrangement manner (an attracted or a repelled manner) of the magnetic body 230 and a sensing direction (for example, a K direction in FIG. 7 or FIG. 8) of the magnetic sensor 240. The sensing direction of the magnetic sensor 240 is parallel to the second direction. In addition, an orientation of the sensing direction of the magnetic sensor 240 may depend on a mounting direction of the magnetic sensor 240.

FIG. 7 is a diagram in which sensing directions of magnetic sensors on two sides of a moving component are the same according to an embodiment of this application. As shown in FIG. 7, when the two magnetic bodies 230 are disposed in an attracted manner, and the sensing directions of the magnetic sensors 240 on the two sides of the moving component 110 are the same, magnetic field strength on the two sides of the moving component 110 are added together. When the two magnetic bodies 230 are disposed (not shown in the figure) in a repelled manner, and the sensing directions of the magnetic sensors 240 on the two sides of the moving component 110 are opposite, magnetic field strength on the two sides of the moving component 110 are added together.

FIG. 8 is a diagram in which sensing directions of magnetic sensors on two sides of a moving component are opposite according to an embodiment of this application. As shown in FIG. 8, when the two magnetic bodies 230 are disposed in an attracted manner, and the sensing directions of the magnetic sensors 240 on the two sides of the moving component 110 are opposite, magnetic field strength on the two sides of the moving component 110 are subtracted from each other. When the two magnetic bodies 230 are disposed (not shown in the figure) in a repelled manner, and the sensing directions of the magnetic sensors 240 on the two sides of the moving component 110 are the same, magnetic field strength on the two sides of the moving component 110 are subtracted from each other.

Therefore, when the sensing directions of the magnetic sensors 240 on the two sides of the moving component 110 are determined, an operation manner of the magnetic field strength detected by the magnetic sensor 240 on the left side and the magnetic field strength detected by the magnetic sensor 240 on the right side depends on an arrangement of the two magnetic bodies 230. For example, when the sensing directions of the magnetic sensors 240 on the two sides of the moving component 110 are the same, the two magnetic bodies 230 are disposed in an attracted manner. Correspondingly, magnetic field strength detected by all magnetic sensors 240 is added together. In this way, a precision error caused by a change of the spacing between the magnetic body 230 and the magnetic sensor 240 may be compensated, and position detection precision may be improved. When the sensing directions of the magnetic sensors 240 on the two sides of the moving component 110 are the same, and the two magnetic bodies 230 are disposed in a repelled manner in the second direction, magnetic field strength detected by the magnetic sensors 240 of each group of stationary units 220 are added together, and then magnetic field strength detected by the two groups of stationary units 220 are subtracted from each other. In this way, a precision error caused by a change of the spacing between the magnetic body 230 and the magnetic sensor 240 may be compensated, and position detection precision may be improved.

It should be noted that, in this embodiment of this application, an example in which the sensing directions of the magnetic sensors 240 on the two sides of the moving component 110 are the same is used to describe an operation manner of the magnetic field strength.

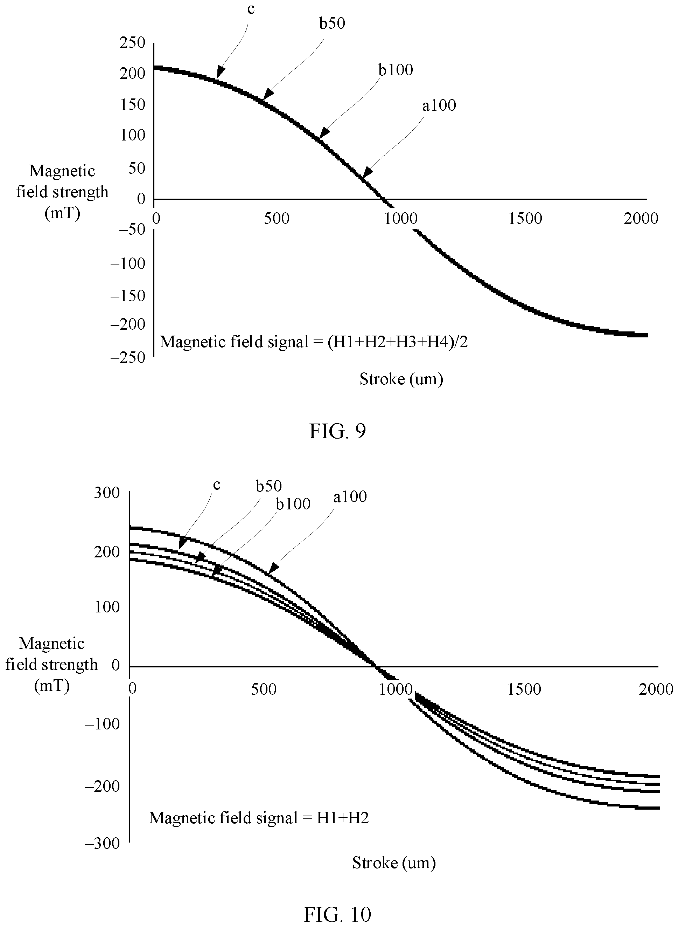

FIG. 9 is a diagram of detection effect of the embodiment shown in FIG. 6. In FIG. 9, H1, H2, H3, and H4 each represent one magnetic sensor 240, and two magnetic bodies 230 are disposed in an attracted manner in a second direction. (H1+H2+H3+H4) represents an addition operation existing when the two magnetic bodies 230 are disposed in an attracted manner. In FIG. 9, a100 represents that a spacing in the second direction between the magnetic body 230 and the magnetic sensor 240 decreases by 100 um, b100 represents that the spacing in the second direction between the magnetic body 230 and the magnetic sensor 240 increases by 100 um, b150 represents that the spacing in the second direction between the magnetic body 230 and the magnetic sensor 240 increases by 150 um, and c represents that the spacing in the second direction between the magnetic body 230 and the magnetic sensor 240 does not change. It may be learned from FIG. 9 that, when the spacing in the second direction between the magnetic body 230 and the magnetic sensor 240 changes, magnetic field strength may not change in a same stroke.

FIG. 10 is a diagram of detection effect of a camera module in a conventional technology. H1 and H2 in FIG. 10 represent an addition operation of magnetic field strength detected by two Hall effect sensors 710. It may be learned from FIG. 10 that after a spacing between an induction magnet 720 and the Hall effect sensor 710 changes, the magnetic field strength detected by the Hall effect sensor 710 may change (increase or decrease) in a same stroke.

Therefore, it can be learned from a comparison between FIG. 9 and FIG. 10 that, in an arrangement manner of the magnetic body 230 and the magnetic sensor 240 provided in this embodiment of this application, a precision error caused by a change of the spacing between the magnetic body 230 and the magnetic sensor 240 may be compensated, accuracy of the magnetic field strength detected by the magnetic sensor 240 may be improved, and position detection precision may be improved.

In conclusion, in the camera module 10 provided in this embodiment of this application, the magnetic body 230 and the magnetic sensor 240 that cooperate with each other are respectively disposed on the two opposite sides of the moving component 110. The spacing in the second direction between the magnetic sensors 240 on the two sides remains unchanged. Therefore, when the moving component 110 deviates in the second direction, the magnetic field strength detected by the magnetic sensor 240 on one side increases, and the magnetic field strength detected by the magnetic sensor 240 on the other side decreases. The magnetic field strength detected by the magnetic sensors 240 on the two sides of the moving component 110 are calculated, to improve position detection precision.

The following describes in detail a position detection unit 220 in this embodiment of this application by using an example in which the movable member 210 is a magnetic body 230 and the stationary member 221 is a magnetic sensor 240.

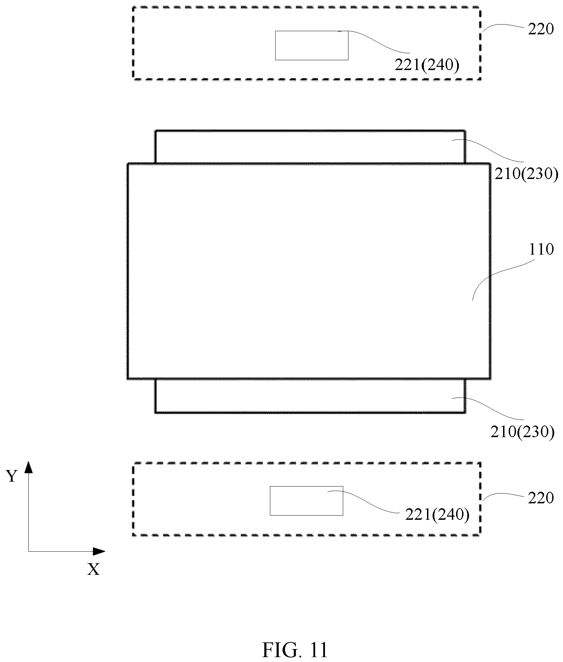

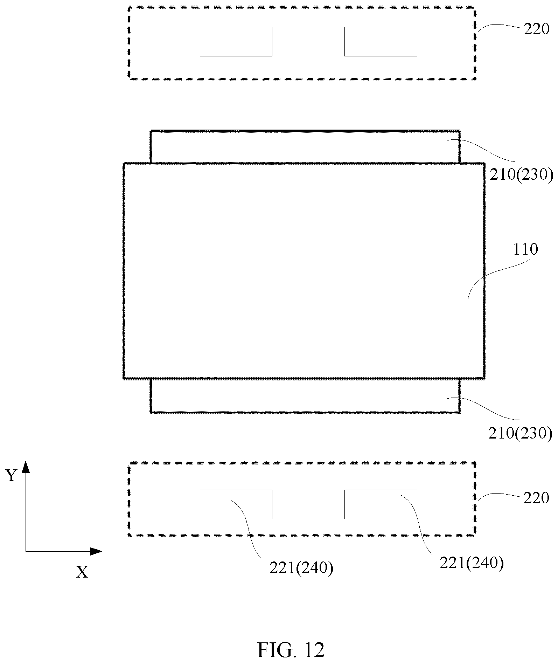

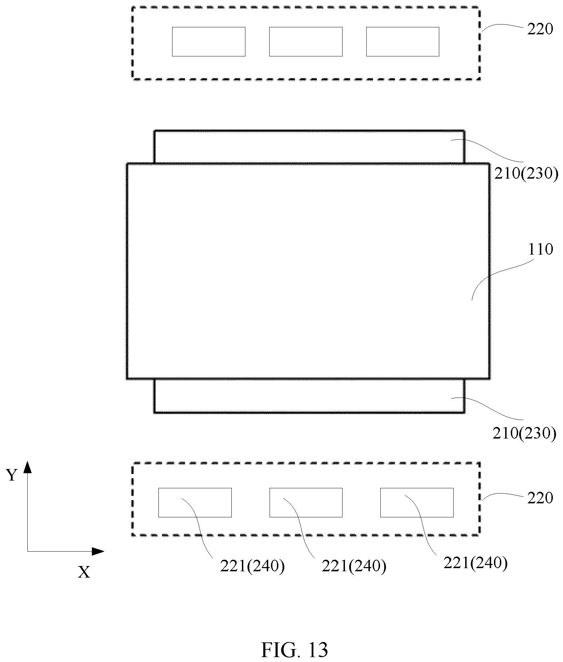

FIG. 11 is a diagram of a structure of a first position detection unit according to an embodiment of this application. FIG. 12 is a diagram of a structure of a second position detection unit according to an embodiment of this application. FIG. 13 is a diagram of a structure of a third position detection unit according to an embodiment of this application.

In some possible implementations, each group of stationary units 220 includes a same quantity of stationary members 221. This disposing helps improve position detection precision.

A quantity of stationary members 221 included in each group of stationary units 220 may be determined based on factors such as a use requirement and internal space of the camera module 10. For example, the quantity of stationary members 221 in each group of stationary units 220 may be 1, 2, 3, 4, or the like. Therefore, a quantity ratio of stationary members 221 in the two groups of stationary units 220 is 1:1 (as shown in FIG. 9), 2:2 (as shown in FIG. 10), 3:3 (as shown in FIG. 11), 4:4, 5:5, or the like.

It should be noted that a larger quantity of magnetic sensors 240 indicates that a magnetic field strength-stroke curve (a curve shown in FIG. 9) fitted by magnetic field strength detected by the magnetic sensor 240 is closer to a straight line. In other words, a larger quantity of magnetic sensors 240 helps improve linearity. Higher linearity indicates that current magnetic field strength detected by the magnetic sensor 240 is closer to determined magnetic field strength. This helps improve position detection precision.

In some examples, in the first direction, all stationary members 221 of the one group of stationary units 220 are in a one-to-one correspondence with all stationary members 221 of the other group of stationary units 220 (as shown in FIG. 11 to FIG. 13). In other words, the magnetic sensors 240 on the two sides of the moving component 110 are symmetrically disposed. This disposing helps improve an overlapping degree, so that a magnetic field strength-stroke curve formed by fitting the magnetic field strength detected by the magnetic sensor 240 and a stroke is a curve. This helps improve position detection precision. For example, as shown in FIG. 12, each group of stationary units 220 may include two magnetic sensors 240, and the two magnetic sensors 240 of the two groups of stationary units 220 are respectively symmetrically disposed.

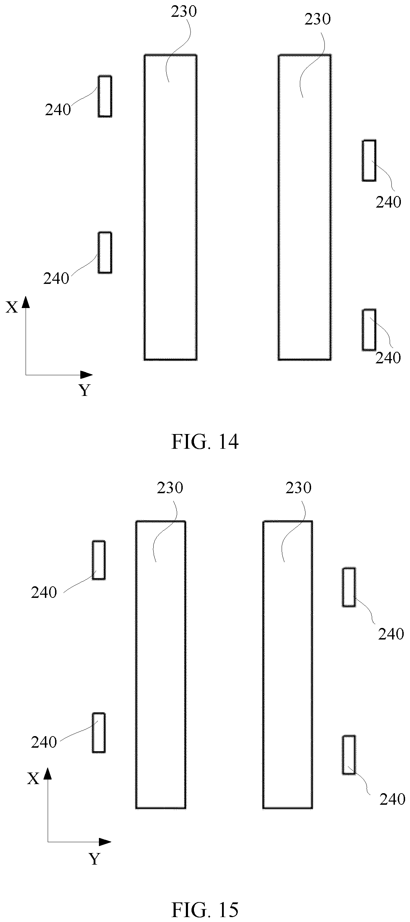

FIG. 14 is a diagram of a structure of a fourth position detection unit according to an embodiment of this application. FIG. 15 is a diagram of a structure of a fifth position detection unit according to an embodiment of this application.

In some other examples, in the first direction, the magnetic sensors 240 on the two sides of the moving component 110 may be arranged in a staggered manner in the first direction. For example, as shown in FIG. 14, each group of stationary units 220 may include two magnetic sensors 240. In the first direction, all magnetic sensors 240 are sequentially arranged at spacings. Alternatively, as shown in FIG. 15, one magnetic sensor 240 of one group of stationary units 220 partially overlaps another magnetic sensor 240 of the other group of stationary units 220.

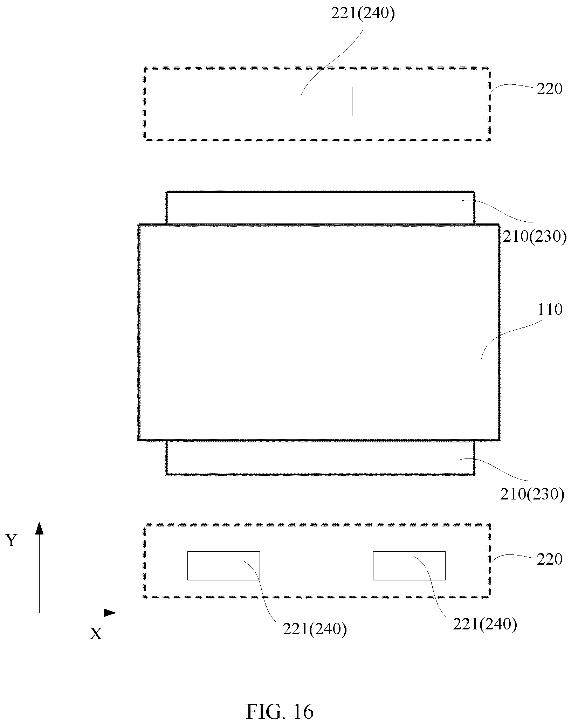

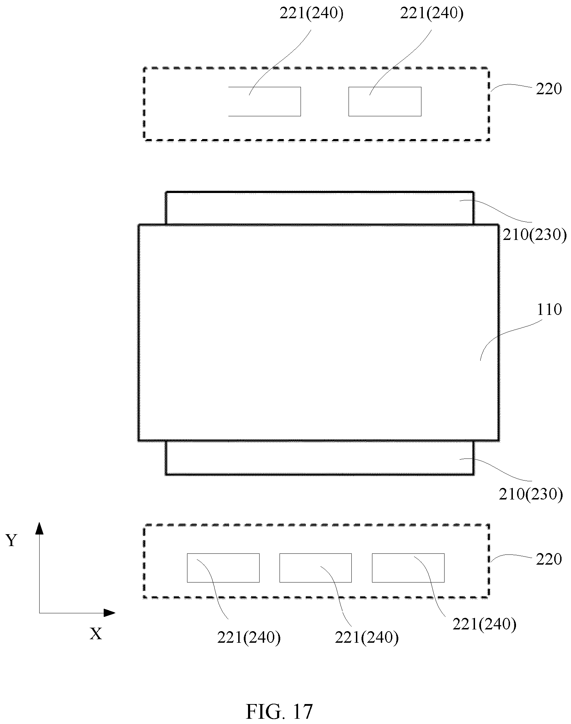

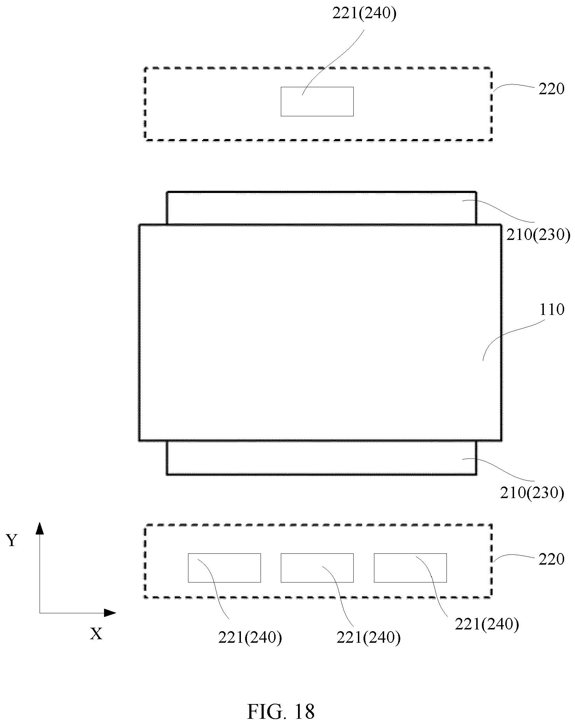

FIG. 16 is a diagram of a structure of a sixth position detection unit according to an embodiment of this application. FIG. 17 is a diagram of a structure of a seventh position detection unit according to an embodiment of this application. FIG. 18 is a diagram of a structure of an eighth position detection unit according to an embodiment of this application.

In some possible implementations, as shown in FIG. 16, the two groups of stationary units 220 have different quantities of stationary members 221. In other words, there is a difference between a quantity of stationary members 221 of one group of stationary units 220 in the two groups of stationary units 220 and a quantity of stationary members 221 of the other group of stationary units 220. This disposing helps improve an application range of the position detection unit 220, and may improve position detection precision.

It can be understood that, as shown in FIG. 16, the moving component 110 is used as a center. A quantity of all magnetic sensors 240 on a top side of the moving component 110 may be smaller than a quantity of all magnetic sensors 240 on a bottom side of the moving component 110. Alternatively, a quantity of all magnetic sensors 240 on a bottom side of the moving component 110 may be greater than a quantity of all magnetic sensors 240 on a top side of the moving component 110.

It should be noted that the difference between the quantity of stationary members 221 of one group of stationary units 220 and the quantity of stationary members 221 of the other group of stationary units 220 is a positive integer. For example, the difference between the quantity of stationary members 221 of one group of stationary units 220 and the quantity of stationary members 221 of the other group of stationary units 220 may be 1, 2, 3, or the like. Examples are as follows.

In some examples, as shown in FIG. 16, the quantity of stationary members 221 of the one group of stationary units 220 is 1, and the quantity of stationary members 221 of the other group of stationary units 220 is 2. Therefore, a difference between the stationary members 221 of the two groups of stationary units 220 is 1.

In some other examples, as shown in FIG. 17, the quantity of stationary members 221 of the one group of stationary units 220 is 2, and the quantity of stationary members 221 of the other group of stationary units 220 is 3. Therefore, a difference between the stationary members 221 of the two groups of stationary units 220 is 1.

In some other examples, as shown in FIG. 18, the quantity of stationary members 221 of the one group of stationary units 220 is 1, and the quantity of stationary members 221 of the other group of stationary units 220 is 3. Therefore, a difference between the stationary members 221 of the two groups of stationary units 220 is 2.

To ensure an overlapping degree of a magnetic field strength-stroke curve fitted by magnetic field strength detected by the two groups of stationary units 220 and a stroke, and enable the magnetic field strength-stroke curve to be a curve, all stationary members 221 of stationary units 220 of a smaller quantity are disposed at spacings. In addition, all stationary members 221 of stationary units 220 of a smaller quantity are located in the middle relative to all stationary members 221 of stationary units 220 of a greater quantity in the first direction, so that the two groups of stationary units 220 are symmetrically disposed on the two opposite sides of the moving components 110. Examples are as follows.

In some examples, as shown in FIG. 16, one group of stationary units 220 includes one magnetic sensor 240, and the other group of stationary units 220 includes two magnetic sensors 240. The magnetic sensor 240 of the one group of stationary units 220 is located in the middle relative to the two magnetic sensors 240 of the other group of stationary units 220 in the first direction.

In some other examples, as shown in FIG. 17, one group of stationary units 220 includes two magnetic sensors 240, and the other group of stationary units 220 includes three magnetic sensors 240. The two magnetic sensors 240 of the one group of stationary units 220 and the three magnetic sensors 240 of the other group of stationary units 220 are disposed at spacings in the first direction, and the two sensors of the one group of stationary units 220 are separately located in the middle relative to two adjacent magnetic sensors 240 of the other group of stationary units 220.

In another example, as shown in FIG. 18, one group of stationary units 220 includes one magnetic sensor 240, and the other group of stationary units 220 includes three magnetic sensors 240. The magnetic sensor 240 of the one group of stationary units 220 is disposed opposite to a magnetic sensor 240 in the middle of the three magnetic sensors 240 of the other group of stationary units 220 in the second direction.

In some possible implementations, the magnetic sensor 240 is any one of the following sensors: a Hall effect sensor 710, a giant magnetoresistance sensor, a tunneling magnetoresistance sensor, an anisotropic magnetoresistance sensor, or a sensor-integrated signal processing chip.

It should be noted that, when each group of stationary units 220 includes a plurality of magnetic sensors 240, types of all magnetic sensors 240 of each group of stationary units 220 may be the same, or each group of stationary units 220 includes at least two types of magnetic sensors 240. For example, each group of stationary units 220 includes a Hall effect sensor 710 and a giant magnetoresistance sensor. In addition, the types of the magnetic sensors 240 of the two groups of stationary units 220 may alternatively be the same. For example, the magnetic sensors 240 of the two groups of stationary units 220 may be Hall effect sensors 710.

It can be understood that all magnetic sensors 240 of the position detection unit 220 may be magnetic sensors 240 of a same type. This helps reduce adaptation difficulty and assembly difficulty of the position detection unit 220, and may reduce manufacturing costs.

In some possible implementations, the magnetic body 230 may be a two-pole magnetic body 230 magnetized by using two poles, and an N pole and an S pole of the two-pole magnetic body 230 are sequentially arranged in the first direction.

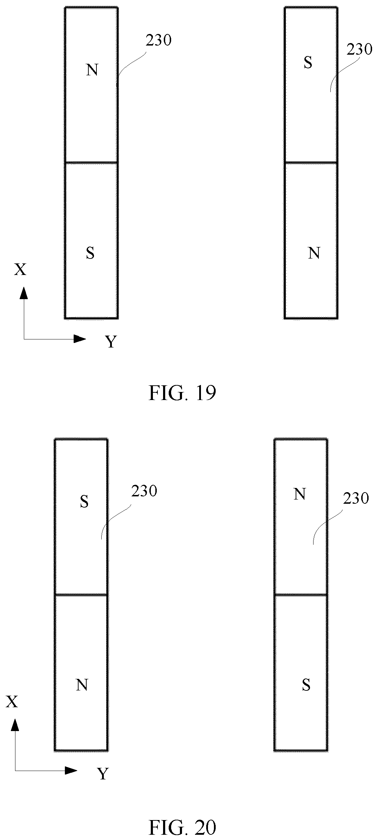

FIG. 19 is a diagram in which two magnetic bodies are disposed in an attracted manner according to an embodiment of this application. FIG. 20 is another diagram in which two magnetic bodies are disposed in an attracted manner according to an embodiment of this application.

As shown in FIG. 19 or FIG. 20, when two magnetic bodies 230 are disposed in an attracted manner, an N pole of one magnetic body 230 is disposed opposite to an S pole of the other magnetic body 230 in the second direction, and an S pole of the one magnetic body 230 is disposed opposite to an N pole of the other magnetic body 230 in the second direction.

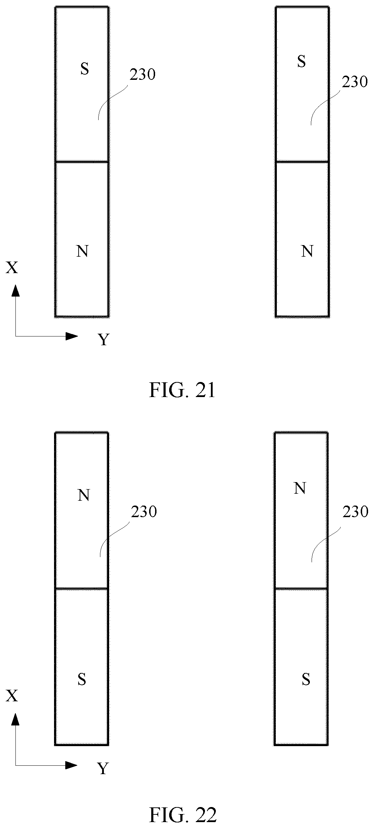

FIG. 21 is a diagram in which two magnetic bodies are disposed in a repelled manner according to an embodiment of this application. FIG. 22 is another diagram in which two magnetic bodies are disposed in a repelled manner according to an embodiment of this application.

As shown in FIG. 21 or FIG. 22, when two magnetic bodies 230 are disposed in a repelled manner, an N pole of one magnetic body 230 is disposed opposite to an N pole of the other magnetic body 230 in the second direction, and an S pole of the one magnetic body 230 is disposed opposite to an S pole of the other magnetic body 230 in the second direction.

Optionally, a neutral region may be further disposed between the N pole and the S pole of the magnetic body 230. The neutral region may be disposed opposite to the magnetic sensor 240, or the neutral region may not be disposed opposite to the magnetic sensor 240.

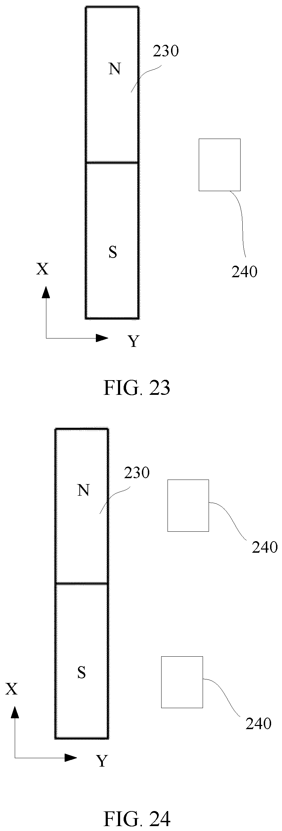

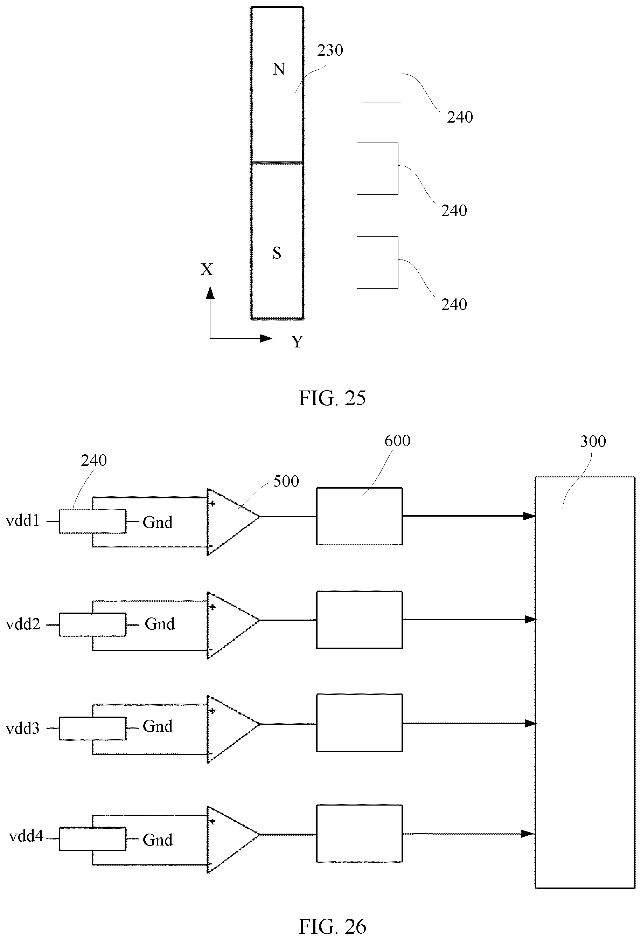

To improve detection precision, when there is one magnetic sensor 240 corresponding to each magnetic body 230, FIG. 23 is a diagram of cooperation between a magnetic body and a magnetic sensor according to an embodiment of this application. As shown in FIG. 23, the magnetic sensor 240 is located in the middle of the magnetic body 230 in a first direction. In other words, the magnetic sensor 240 is opposite to a joint between an N pole and an S pole of the magnetic body 230. When there are two magnetic sensors 240 corresponding to each magnetic body 230, FIG. 24 is another diagram of cooperation between a magnetic body and a magnetic sensor according to an embodiment of this application. As shown in FIG. 24, an N pole and an S pole of the magnetic body 230 each correspond to one magnetic sensor 240. In addition, the magnetic sensor 240 may be located at a center of the N pole or the S pole. When there are three magnetic sensors 240 corresponding to each magnetic body 230, FIG. 25 is still another diagram of cooperation between a magnetic body and a magnetic sensor according to an embodiment of this application. As shown in FIG. 25, an S pole, an N pole, and a joint between the S pole and the N pole of the magnetic body 230 each correspond to one magnetic sensor 240.

It should be noted that, when the magnetic body 230 has a neutral region, the magnetic sensor 240 opposite to the joint between the N pole and the S pole of the magnetic body 230 is changed to be disposed opposite to the neutral region.

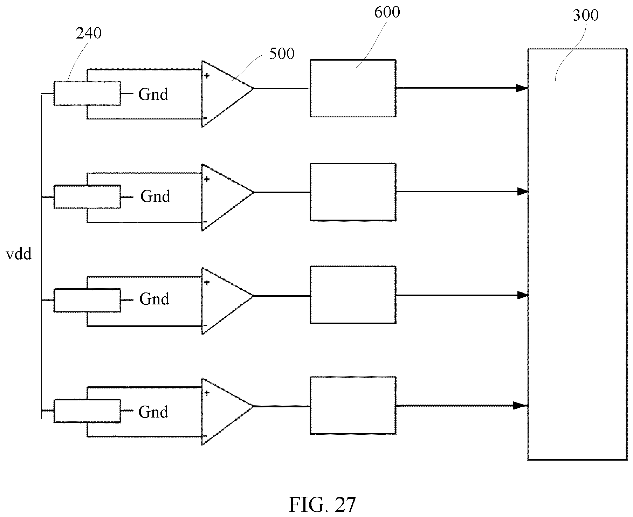

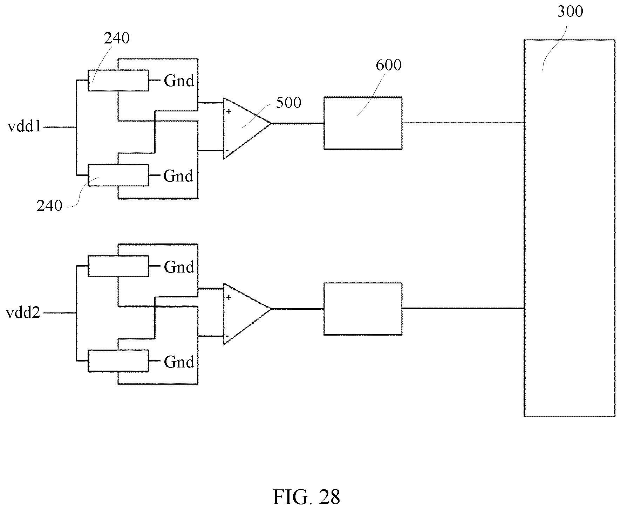

FIG. 26 is a diagram of a connection between a magnetic sensor and a control unit according to an embodiment of this application. FIG. 27 is a diagram of another connection between a magnetic sensor and a control unit according to an embodiment of this application. FIG. 28 is a diagram of still another connection between a magnetic sensor and a control unit according to an embodiment of this application. It should be noted that in FIG. 26 to FIG. 28, vdd is equivalent to a positive supply voltage, and Gnd is equivalent to a negative supply voltage.

In some possible implementations, as shown in FIG. 26 and FIG. 27, to send magnetic field strength detected by the magnetic sensor 240 to the control unit 300, each magnetic sensor 240 is electrically connected to the control unit 300. Alternatively, as shown in FIG. 28, all magnetic sensors 240 of each group of stationary units 220 are electrically connected to a same connection end of the control unit 300. This helps reduce a quantity of connection ends occupying the control unit 300, and may improve an application range of the position detection unit 220.

Optionally, as shown in FIG. 26 to FIG. 28, the following may be further included: an amplifier 500 and an analog-to-digital converter 600. An output end of the analog-to-digital converter 600 is electrically connected to a connection end of the control unit 300, an input end of the analog-to-digital converter 600 is electrically connected to an output end of the amplifier 500, and two input ends of the amplifier 500 are electrically connected to two interfaces of the magnetic sensor 240.

The following describes in detail a connection solution between the magnetic sensor 240 and the control unit 300 by using an example in which each group of stationary units 220 includes two magnetic sensors 240.

As shown in FIG. 26, each magnetic sensor 240 is electrically connected to a power supply, and each magnetic sensor 240 is electrically connected to a connection end of the control unit 300 by using an amplifier 500 and an analog-to-digital amplifier 500, so that each magnetic sensor 240 is electrically connected to the control unit 300.

As shown in FIG. 27, four magnetic sensors 240 are electrically connected to a same power supply, and each magnetic sensor 240 is electrically connected to a connection end of the control unit 300 by using an amplifier 500 and an analog-to-digital amplifier 500, so that each magnetic sensor 240 is electrically connected to the control unit 300.

As shown in FIG. 28, two magnetic sensors 240 of each group of stationary units 220 are electrically connected to a same power supply, and the two magnetic sensors 240 of each group of stationary units 220 are electrically connected to a connection end of the control unit 300 by using an amplifier 500 and an analog-to-digital amplifier 500, so that all magnetic sensors 240 of each group of stationary units 220 are electrically connected to a same connection end of the control unit 300.

It should be noted that, when all magnetic sensors 240 of one group of stationary units 220 are electrically connected to a connection end of the control unit 300 by using an amplifier 500 and an analog-to-digital converter 600, all magnetic sensors 240 of the other group of stationary units 220 are electrically connected to a connection end of the control unit 300 by using an amplifier 500 and an analog-to-digital amplifier 500, and the control unit 300 performs an operation on magnetic field signals uploaded by the two groups of stationary units 220, a sum of magnetic field signals uploaded by each group of stationary units 220 needs to be divided by 2, to ensure that magnetic field strength remains unchanged.

In descriptions of embodiments of this application, it should be noted that, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

In embodiments of this application, it is not implied that a described apparatus or element needs to have a particular orientation or be configured and operated in a particular orientation. Therefore, this cannot be understood as a limitation on this application. In the descriptions of embodiments of this application, unless otherwise exactly and specifically ruled, "a plurality of" means two or more.

In this specification, claims, and accompanying drawings of embodiments of this application, the terms "first", "second", "third", "fourth", and so on (if existent) are intended to distinguish between similar objects but do not necessarily indicate a specific order or sequence. It should be understood that data used in such a way is interchangeable in a proper circumstance, so that embodiments of this application described herein can be implemented in other orders than the order illustrated or described herein. Moreover, the terms "include", "contain" and any variant thereof are intended to cover a non-exclusive inclusion. For example, a process, method, system, product, or device that includes a list of steps or units is not necessarily limited to those steps or units that are expressly listed, but may include other steps or units not expressly listed or are inherent to the process, method, product, or device.

The term "a plurality of" in this specification means two or more. The term "and/or" in this specification describes only an association relationship for describing associated objects and indicates that three relationships may exist. For example, A and/or B may indicate the following three cases: Only A exists, both A and B exist, and only B exists. In addition, the character "/" in this specification usually indicates an "or" relationship between the associated objects. In the formula, the character "/" indicates a "division" relationship between the associated objects.

It can be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined according to functions and internal logic of the processes, and should not be construed as any limitation the implementation processes of embodiments of this application.

## Claims

1. A camera module, comprising at least an imaging unit and a position detection unit, wherein
the imaging unit comprises a moving component moving in a first direction;
the position detection unit comprises two movable members and two groups of stationary units;
the two movable members are respectively fastened and mounted at two opposite ends of the moving component and located between the two groups of stationary units, the two movable members are disposed at a spacing in a second direction, and the second direction is perpendicular to the first direction;
each group of stationary units comprises at least one stationary member, the two groups of stationary units are disposed opposite to each other in the second direction, and when each group of stationary units comprises a plurality of stationary members, the plurality of stationary members of each group of stationary units are disposed at spacings in the first direction;
one of the movable member and the stationary member is a magnetic body, and the other of the movable member and the stationary member is a magnetic sensor; and
the magnetic sensor is configured to detect magnetic field strength of the magnetic body corresponding to the magnetic sensor.

2. The camera module according to claim 1, wherein the movable member is a magnetic body, and the stationary member is a magnetic sensor.

3. The camera module according to claim 2, wherein each group of stationary units comprises a same quantity of stationary members.

4. The camera module according to claim 3, wherein each group of stationary units comprises one stationary member, two stationary members, or three stationary members.

5. The camera module according to claim 3 or 4, wherein all stationary members of one group of stationary units are in a one-to-one correspondence with all stationary members of the other group of stationary units.

6. The camera module according to claim 2, wherein the two groups of stationary units have different quantities of stationary members.

7. The camera module according to claim 6, wherein a difference between a quantity of stationary members of one group of stationary units of the two groups of stationary units and a quantity of stationary members of the other group of stationary units is 1, 2, or 3.

8. The camera module according to claim 7, wherein the one group of stationary units comprises one stationary member, and the other group of stationary units comprises two or three stationary members.

9. The camera module according to claim 8, wherein when the other group of stationary units comprises two stationary members, the stationary member of the one group of stationary units is located in the middle relative to the two stationary members of the other group of stationary units; or
when the other group of stationary units comprises three stationary members, the stationary member of the one group of stationary units is disposed opposite to a stationary member in the middle of the three stationary members of the other group of stationary units in the second direction.

10. The camera module according to any one of claims 2 to 9, wherein the two magnetic bodies are disposed in the second direction in an attracted manner, or the two magnetic bodies are disposed in the second direction in a repelled manner.

11. The camera module according to any one of claims 1 to 10, wherein the magnetic sensor is any one of the following sensors: a Hall effect sensor, a giant magnetoresistance sensor, a tunneling magnetoresistance sensor, an anisotropic magnetoresistance sensor, or a sensor-integrated signal processing chip.

12. The camera module according to any one of claims 1 to 11, wherein the moving component is a lens group or a photosensitive chip; and
when the moving component is the lens group, the lens group comprises at least one lens moving in the first direction, and the two movable members are fastened and mounted on a same lens.

13. The camera module according to any one of claims 1 to 12, further comprising a control unit, wherein
each magnetic sensor is electrically connected to the control unit; and
the control unit is configured to receive a magnetic field signal uploaded by each magnetic sensor, and determine a position of the moving component based on all magnetic field signals.

14. The camera module according to claim 13, further comprising a driving unit, wherein the driving unit is electrically connected to the control unit and is mechanically connected to the moving component; and
the control unit is further configured to control, based on the magnetic field signal, the driving unit to drive the moving component to move in the first direction.

15. The camera module according to claim 13 or 14, wherein each magnetic sensor is electrically connected to the control unit; or
all magnetic sensors of each group of stationary units are electrically connected to a same connection end of the control unit.

16. The camera module according to any one of claims 1 to 15, wherein the magnetic body is a magnetite or a magnet.

17. An electronic device, comprising a housing and the camera module according to any one of claims 1 to 16, wherein the camera module is disposed on the housing.
